# EUROPEAN PATENT APPLICATION

(11) **EP 3 267 307 A1**
(43) Date of publication of application: **10.01.2018**
(21) Application number: 16177833.7
(22) Date of filing: 04.07.2016
(51) Int. Cl.: G06F 9/44, G06F 17/50

(54) **ACCESS CONTROL SYSTEM AND METHOD**

(71) Applicant: DinBox Sverige AB, 113 26 Stockholm (SE)
(72) Inventor: Årman, Anders, 113 26 Stockholm (SE)
(74) Representative: Awapatent AB

(57) **Abstract**

In an access control system (100), input signals are received by an input section (110) from at least one input device (130) such as a tag reader (134), a magnetic reader (135) or a biometric reader. Signals are provided by the input section through one or more input channels (140) of a logic section (120) based on the input signals. The signals received through the input channels are converted by the logic section into output signals by employing a function formed by one or more computer program modules (121-126). The function is editable by selecting the modules from a collection of available computer program module types (211, 213, 215, 218) and by selecting how to connect the selected modules. The logic section outputs the output signals through one or more output channels (150) for controlling at least one element (160), such as an electric lock (161) or an opening mechanism (162) for a door (163). Editing of the function allows the system to apply different access rules.

## Description

### Technical field

The present disclosure generally relates to systems and methods for controlling access to physical locations such as areas, buildings, rooms, or lockers.

### Background

Doors leading into a room may be locked in order to prevent unauthorized persons to enter the room. When an authorized person is identified via for example a pin code, a tag reader, a magnetic card reader or a biometric sensor, the door may be automatically unlocked so as to grant access to the room. The rules applied by an access control system to determine whether to unlock a door may be quite complex. Different persons may have different access rights, which may change over time. Different requirements for unlocking a door may apply for different days of the week, or for different hours during the day. Different requirements may also apply for different persons. For example, some people may need to swipe a card in a card reader and then enter a pin code in order to open a door, while other people may only need to swipe a card in the card reader. In some cases, several people may need to be present at the same time for a door to unlock. In addition to determining whether to unlock a door, an access control system may for example also determine whether to automatically open the door for helping a disabled person to enter the room.

In order to handle the increasing number of available ways to identify a person, and in order to handle the increasing complexity of rules applied for determining whether to grant a person access to restricted areas, it would be advantageous to provide new access control systems and methods.

### Summary

To better address one or more of the abovementioned issues, systems and methods having the features defined in the independent claims are provided. Associated computer program products are also provided. Preferable embodiments are defined in the dependent claims.

Hence, according to a first aspect, an access control system is provided. The access control system comprises an input section configured to receive input signals from at least one input device from the group comprising: a push button, a manual switch, a keypad, a tag reader, an optical reader, a magnetic reader, a wireless receiver, a presence detector, and a biometric reader. The access control system comprises a logic section having input channels (or inputs) for receiving signals from the input section. The logic section has output channels (or outputs) for outputting signals for controlling at least one element from the group comprising: an electric strike (or electric latch release), an actuator, an electric motor, an electric lock, and an opening mechanism for a door. The input section is configured to provide signals through one or more of the input channels based on the input signals. The logic section is configured to employ one or more computer program modules (or macros) together forming a function (or computer program) for converting the signals received through one or more of the input channels into signals output through one or more of the output channels. The function is editable via a computer interface by selecting the one or more computer program modules from a collection of available computer program module types, and by selecting how to connect the one or more selected computer program modules.

By controlling the at least one element based on input signals from the at least one input device, the access control system may be employed for controlling access (via the at least one element) to a physical location such as an area, a building, a room, or a locker. The at least one element may for example be arranged to unlock and/or open a door. The ability to edit the function formed by the computer program modules allows for tailoring of the access control provided by the access control system. The desired rules for how to control access to a particular restricted area may not be known when manufacturing or installing the access control system. The desired rules for how to control access may even change over time. The ability to edit the function formed by the computer program modules allows the access control system to be modified or updated for complying with new desired access rules, in contrast to prior art access control systems which may be manufactured to enforce fixed or predetermined access rules. Prior art access control systems may be difficult to modify in order to apply new access rules. At least in some cases, complete reprogramming of the prior art access control system may be required for the system to be able to enforce a new access rule. Such reprogramming may be difficult for an average user to perform. Compared to completely reprogramming an access control system in order to apply new access rules (which may require in-depth knowledge of the input devices and/or the elements to be controlled), the use of computer program modules facilitates editing of the access control system.

The manual switch may for example be a switch (or switch button) manually operable by a human user. The key pad may for example include a plurality of buttons via which a person may enter a pin code. The tag reader may for example be adapted to employ RFID (radio frequency identification) or NFC (near filed communication) to identify a tag. The optical reader may for example be adapted to read a barcode (for example a regular linear barcode, or a matrix barcode such as QR code), or to employ facial recognition. The magnetic reader may for example be a magnetic card reader or a magnetic stripe reader. The wireless receiver may for example be adapted to receive signals via a wireless protocol or standard such as Bluetooth. The wireless receiver may for example be adapted to receive signals from a hand-held device such as a mobile phone or tablet computer. The presence detector may for example be adapted to detect presence at a short distance (such as up to a few centimeters) or at longer distances (such up to a few meters). The presence detector may for example employ sound or light to detect presence. The biometric reader (or sensor) may for example be adapted to check fingerprints or to perform eye scanning (such as iris recognition or retinal scan).

The input section may for example be configured to receive input signals also from other sources than the at least one input device, such as from a handheld device (e.g. a tablet computer or a mobile phone), the internet or a computer device.

The at least one input device may for example include a keypad, a tag reader, a magnetic reader, an optical reader and/or a biometric reader.

The at least one element may for example include an electric strike, an electric lock, and/or an opening mechanism for a door.

The at least one element may for example be arranged to unlock and/or open a door (to provide access to an area behind the door), or to unlock or open a container (to provide access to the interior or contents of the container).

The computer interface may for example be a wired or wireless interface to which a computer or handheld device may be connected. The access control system may for example include a visual user interface (such as a screen or display) connected to the computer interface.

A user may for example use the computer interface to select the one or more computer program modules from the collection of available computer program module types. The user may for example use the computer interface to select how the one or more selected computer program modules are to be connected to each other, to the input channels, and to the output channels (and whether any of the input channels are to be connected directly to the output channels).

At least some of the input channels of the logic section may be logic channels in the sense that signals received at these channels may be logic signals such as 1 or 0 (or signal level "high" or signal level "low" corresponding to 1 or 0).

At least some of the computer program modules may be logic computer program modules in the sense that they may provide logic signals as output based on logic signals received as input. The output of a logic computer program module may for example also be based on an internal state of the logic computer program module (which state may be caused or determined by earlier received logic signals).

According to some embodiments, the input section may be configured to provide a signal through a certain input channel of the input channels of the logic section in response to a certain criterion being satisfied by at least a subset of the input signals. In other words, the input section may apply the certain criterion to determine whether or not to provide a signal through the certain input channel. Other criterions may for example be applied by the input section to determine whether or not to provide signals to the other input channels of the logic section.

According to some embodiments, the certain criterion may include that the at least a subset of the input signals matches at least one of a plurality of stored entries (or signatures, or identities). A subset of the input signals may for example match a stored entry in the sense that it coincides with, or has similar characteristics as, the stored entry.

The input section may for example de configured to access a memory, storage or lookup table in which the plurality of entries is stored. The memory may for example be located in the input section or at a remote location.

The input signals may for example include an identity detected by a tag reader, a magnetic card reader or a biometric sensor.

According to some embodiments, the certain criterion may include that a stored entry which matches the at least a subset of the input signals is associated with a certain access right. The input section may for example de configured to access a memory, storage or lookup table in which the plurality of entries are stored together with information (or indications) of the associated access rights.

The stored entries may for example be associated with different access rights. One stored entry may for example be associated with multiple access rights. Different access rights may for example be associated with different input channels of the logic section.

According to some embodiments, the input section may be configured to check whether at least a subset of the input signals matches at least one of a plurality of stored entries (or signatures, or identities). The input section may be configured such that if a stored entry which matches the at least a subset of the input signals is associated with a certain attribute, then the input section signals the attribute to the logic section.

The attribute may for example correspond to a numerical value, such as a certain time during which a door controlled by the at least one element is to remain unlocked or open. Different stored entries may for example be associated with different attribute values. Doors may for example be opened for an extra long time if the input signals match a stored entry which is associated with a person using a wheel chair.

The attribute may for example be signaled to the logic section using a channel distinct (or separate) from the input channels of the logic section.

According to some embodiments, the collection of computer program module types may include a computer program module which has an output channel and which is adapted to provide a signal at its output channel based on the attribute. A duration, amplitude or frequency of the signal provided at the output channel may for example be determined (or controlled) based on the attribute.

According to some embodiments, the collection of available computer program module types may include a computer program module (which may be referred to as a first computer program module) having an input channel and an output channel. The (first) computer program module may be adapted to provide a pulse or an impulse at its output channel in response to receiving a signal at its input channel. The pulse may for example be provided in the form of a voltage pulse or in the form of a current pulse. The impulse may for example be provided in the form of a voltage impulse or in the form of a current impulse.

The pulse or impulse provided by the (first) computer program module may for example be suitable for controlling an electric strike, an actuator, an electric motor, and electric lock, and/or an opening mechanism for a door.

According to some embodiments, the pulse provided at the output channel may have a length or amplitude determined based on an attribute signaled by the input section.

According to some embodiments, the impulse provided at the output channel may have an amplitude determined based on an attribute signaled by the input section.

According to some embodiments, the collection of available computer program module types may include a computer program module (which may be referred to as a second computer program module) having a plurality of input channels and an output channel. The (second) computer program module may be adapted to provide a signal (for example a predefined signal, such as 1 or voltage level "high") at its output channel in response to signals (for example predefined signals, such as 1 or voltage level "high") having been received at all of the plurality of input channels of the (second) computer program module (similarly to an AND-gate). The signals may for example just have been received at the input channels, or one or more of the signals may have been received at an earlier point in time for one or more of the input channels. In other words, the (second) computer program module may have memory functionality (or memory function) at its input channels. The plurality of input channels may for example include more than 2 input channels, or may include no more than 2 input channels.

According to some embodiments, the collection of available computer program modules may include a computer program module (which may be referred to as a third computer program module) having a plurality of input channels and an output channel. The (third) computer program module may be adapted to provide a signal (for example a predefined signal, such as 1 or voltage level "high") at its output channel in response to at least one signal (for example a predefined signal, such as 1 or voltage level "high") having been received at one or more of its input channels (similarly to an OR-gate). The signal(s) may for example just have been received at one or more of the plurality of input channels, or the signal(s) may have been received at an earlier point in time. In other words, the (third) computer program module may have memory functionality (or memory function) at its input channels. The plurality of input channels may for example include more than 2 input channels, or may include no more than 2 input channels.

According to some embodiments, the input section may be adapted to forward signals from an input device of the at least one input device to at least one input channel of the logic section. In other words, some signals from the at least one input device may be received by the logic section without having being processed at the input section.

According to some embodiments, the access control system may comprise the at least one input device. The access control system may for example comprise a keypad, a tag reader, a magnetic reader, an optical reader and/or a biometric reader.

Even after having been mounted or installed on site (such that the input section is connected to the at least one input device and the logic section is connected to the at least one element), the access control system may be editable via the computer interface.

According to some embodiments, the access control system may comprise the at least one element.

According to a second aspect, there is provided an access control method. The method comprises receiving input signals from at least one input device from the group comprising: a push button, a manual switch, a keypad, a tag reader, an optical reader, a magnetic reader, a wireless receiver, a presence detector, and a biometric reader. The method comprises providing signals through one or more input channels based on the input signals. The method comprises converting the signals received through the one or more input channels into output signals by employing a function formed by one or more computer program modules. The function is editable by selecting the one or more computer program modules from a collection of available computer program module types and by selecting how to connect the one or more selected computer program modules. The method comprises outputting the output signals through one or more output channels for controlling at least one element from the group comprising:an electric strike, an actuator, an electric motor, an electric lock, and an opening mechanism for a door.

Access control methods according to the second aspect may for example comprise any of the steps performed by the access control systems of the first aspect during use (or when performing access control).

The advantages presented above for features of access control systems, according to the first aspect, may generally be valid for the corresponding features of access control methods according to the second aspect.

According to a third aspect, there is provided a computer program product comprising a computer-readable medium with instructions for performing the method according to any embodiment of the second aspect.

The advantages presented above for features of systems, according to the first aspect, may generally be valid for the corresponding features of computer programs products according to the third aspect.

The computer-readable medium may for example store or carry instructions for causing a computer to perform the method according to any embodiment of the second aspect.

The computer-readable medium may for example be a transitory storage medium (such as a carrier wave), or a non-transitory storage medium (such as a disc or memory storing the instructions).

It is noted that embodiments of the present disclosure relate to all possible combinations of features recited in the claims. Further, it will be appreciated that the various embodiments described for the system, according to the first aspect, are all combinable with embodiments of the method according to the second aspect.

### Brief description of the drawings

In what follows, example embodiments will be described in greater detail and with reference to the accompanying drawings, on which:
Fig. 1 is an overview of an access control system according to an embodiment;
Fig. 2 shows a graphical user interface which may be employed to edit functionality of the access control system shown in Fig. 1;
Fig. 3 is an overview of the access control system shown in Fig. 1, but where the functionality of the access control system has been edited;
Fig. 4 is a flow chart of an access control method according to an embodiment.

All the figures are schematic and generally only show parts which are necessary in order to elucidate the respective embodiments, whereas other parts may be omitted or merely suggested.

### Detailed description

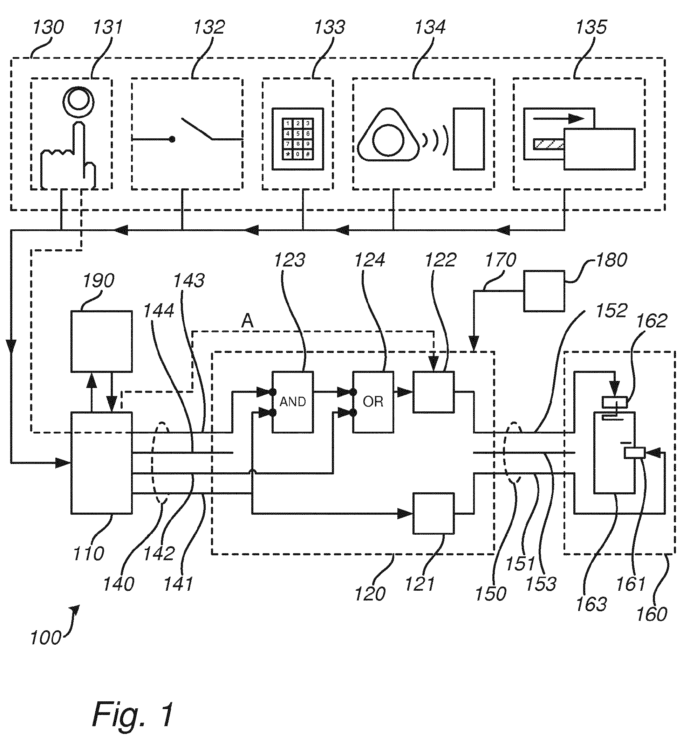

Fig. 1 is an overview of an access control system 100, according to an embodiment. The system 100 comprises an input section 110 and a logic section 120.

The input section 110 is configured to receive input signals from one or more input devices 130. The input devices 130 may for example include a push button 131, a manual switch 132, a keypad 133, a tag reader 134, a magnetic reader 135, an optical reader, a wireless receiver, a presence detector, and/or a biometric reader. The input devices 130 may for example be devices employed by a person to request access to a physical location, such as a room behind a locked door. The input devices 130 may for example be employed to request a door to be unlocked and/or opened.

The logic section 120 has input channels 140 (or inputs) for receiving signals from the input section 110 and output channels 150 (or outputs) for outputting signals so as to control one or more elements 160. The one or more elements 160 may for example include an electric lock 161, an opening mechanism 162 for a door 163, an electric strike (for the door 163), an actuator (for unlocking or opening the door 163), and/or an electric motor (for unlocking or opening the door 163). The access control system 100 controls access to a physical location, such as a room or area behind the door 163, by controlling the elements 160.

The input section 110 is configured to provide signals through one or more of the input channels 140 based on the input signals from the input devices 130. The logic section 120 is configured to employ one or more computer program modules 121-124 together forming a function for converting the signals received through one or more of the input channels 140 into signals output through one or more of the output channels 150. The function formed by the computer program modules 121-124 is editable via a computer interface 170. The function is editable by selecting the computer program modules 121-124 from a collection of available computer program module types and by selecting how to connect the selected computer program modules 121-124.

The computer program modules 121-124 may for example be provided in the form of macros.

The computer interface 170 may be wired or wireless. The computer interface 170 may for example be employed to connect a user interface 180 to the logic section 120 for editing the function formed by the computer program modules 121-123. The user interface 180 may for example be provided by a handheld device (such as a mobile phone or tablet computer) wirelessly connected to the logic section 120, or by a remotely located computer connected to the logic section 120 via a network (such as a local network or the internet). The access control system 100 itself may for example comprise a user interface 180 (for example in the form of a touch screen, or a regular screen in combination with a buttons and/or a pointing device) connected to the logic section 120 via the computer interface 170.

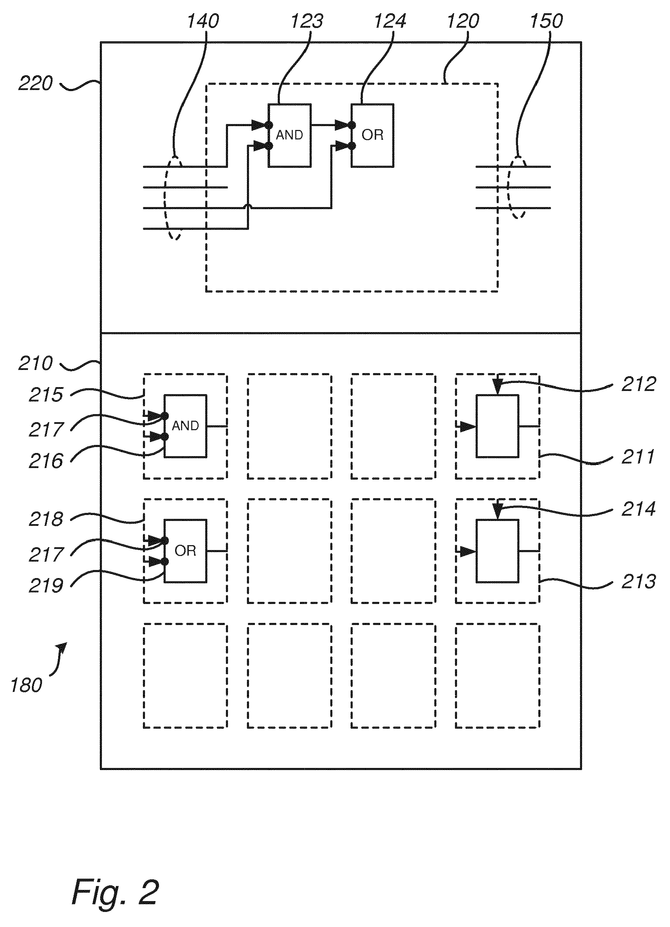

The user interface 180 will now be described with reference to Fig. 2. It will be appreciated that Fig. 2 only serves as an example, and that many different ways of representing, selecting, and connecting computer program modules may be envisaged.

In the present example, the user interface 180 is a graphical user interface (GUI) including screen 180. In a lower portion 210 of the screen 180, a number of computer program module types are shown as icons. A user may for example select computer program modules by clicking the appropriate icon in the lower portion 210 of the screen. In the present example, there are four input channels 140, three output channels 150 and 16 different available computer program module types to choose from. It will be appreciated that access control systems 100 may be envisaged having any number of input channels 140, output channels 150 and available computer program module types.

In an upper portion 220 of the screen 180, the user may choose how to connect the selected computer program modules (for example by placing the selected computer program modules and indicating where to make connections). The upper portion 220 of the screen 180 gives a schematic overview of the logic section 120 showing the input channels 140, the output channels 150, and the already selected computer program modules. The upper portion 220 of the screen also shows how the selected computer program modules have been connected to each other, to the input channels 140 and to the output channels 150. In the present example, only two computer program modules 123 and 124 have been selected and placed in the upper portion 210 of the screen 180. The selected computer program modules 123 and 124 have been connected to the input channels 140 and to each other, but no connections have yet been made to the output channels 150. Further computer program modules and connections may for example be added to provide the same example structure as described further below with reference to Fig. 1.

The graphical user interface 180 provides the user with a simple and intuitive way to tailor the functionality of the logic section 120 without having to reprogram the entire access control system 100. The use of the computer program modules enables editing without any advances programming skills. Even a person lacking detailed (or in-depth) knowledge of the input devices 130 and/or the elements 160 may modify the access control system 100 via the user interface 180 to provide access control according to a desired access rule.

The available computer program module types may for example include computer program modules suitable adapted to provide control, signals suitable for controlling locks, door openers, or other means for unlocking or opening a door.

The available computer program module types may for example include logic computer program modules for transforming logic signals (such as 1 or 0) into other logic signals (such as 1 or 0).

The available computer program module types may for example include a first computer program module 211 (or a first computer program module type 211) having one input channel and one output channel. The first computer program module 211 may be adapted to provide an impulse (e.g. a voltage impulse or current impulse) at its output channel in response to receiving a signal at its input channel. The output provided by the first computer program module 211 may for example be suitable for controlling elements 160 such as an electric strike, an actuator, an electric motor, an electric lock, and/or an opening mechanism for a door. The first computer program module 211 may for example provide impulses at default. The first computer program module 211 may for example be adapted to receive an attribute signal 212 indicating a certain impulse amplitude to employ instead of the corresponding default value. If no such attribute signal is received, the default amplitude may be employed.

The available computer program module types may for example include a second computer program module 215 (or a second computer program module type 215) having two input channels and one output channel. The second computer program module 215 may be adapted to provide a signal at its output channel in response to signals having been received at both of its input channels. In other words, the second computer program module 215 may perform the function of an AND gate with memory at its input terminals. This may be visualized by an AND gate 216 with memory functionality 217 at its input terminals.

The available computer program module types may for example include a third computer program module 218 (or a third computer program module type 218) having two input channels and one output channel. The third computer program module 212 may be adapted to provide a signal at its output channel in response to at least one signal having been received at one or both of its input channels. In other words, the third computer program module 218 may perform the function of an OR gate with memory at its input terminals. This may be visualized by an OR gate 219 with memory functionality 217 at its input terminals.

The available computer program module types may for example include a fourth computer program module 213 (or a fourth computer program module type 213) similar to the first computer program module 211 but adapted to provide a pulse (e.g. a voltage pulse or current pulse) at its output channel in response to receiving a signal at its input channel. The output of provided by the fourth computer program module 213 may for example be suitable for controlling elements 160 such as an electric strike, an actuator, an electric motor, an electric lock, and/or an opening mechanism for a door. The fourth computer program module 213 may provide pulses at default amplitude and default duration. The fourth computer module 213 may be adapted to receive an attribute signal 214 indicating a certain pulse amplitude or pulse duration to employ instead of the default amplitude or duration. If no such attribute signal 214 is received, the default amplitude and/or duration may be employed.

In the example shown in the upper portion 210 of the screen 180, one module 123 of the second type 215 and one module 124 of the third type 218 have currently been selected.

A specific example of access control will now be described with reference to Fig. 1. The access control system 100 controls access to a room by controlling an electric lock 161 for unlocking a door 163 and a door opener 162 for opening the door 163. The input section 110 receives input signals from a tag reader 134 and a push button 131. The door 163 is to be unlocked when an RFID tag of an authorized user is read by the tag reader 134. In the present example, some of the authorized users are disabled and are unable to open the door 163 manually. When the RFID tag of such a user is read by the tag reader 134, the door 163 is to be automatically opened to allow the disabled person to enter. If needed, the push button 131 may be employed by other users to activate the door opener 162. The access control system 100 has been adapted (or prepared, or tailored, or programmed) to provide this functionality.

When a user puts an RFID tag close to the tag reader 134, the input section 110 receives signaling indicating a tag identity. The input section 110 then checks a database 190 of stored entries in the form of tag identities. If the received tag identity matches a stored identity, and if this stored identity is the identity of a user authorized to enter the door 163 (i.e. is associated with the appropriate access right), then a signal is transmitted by the input section 110 at a first input channel 141 of the logic section 120. Further, if this stored identity is the identity of a user listed in the database as disabled, a signal is also transmitted in a second input channel 142 of the logic section 120. The input signals from the push button 131 need not be processed by the input section 110 and may therefore be forwarded by the input section 110 to a third input channel 143 of the logic section 120.

The logic section 120 has a fourth input channel 144 which is not employed in the present example.

Four computer program modules have been selected in the logic section 120. A first module 121 receives the first input channel 141 as input and is connected to a first output channel 151 of the logic section 120. The first input channel 151 is connected to the electric lock 161. The first module 121 provides an impulse to the lock 161 when receiving a signal from the first input channel 141. The impulse causes the lock 161 to unlock the door 163 for a prescribed time. The first module 121 has been provided by selecting the first available computer program module type 211. Depending on the type of lock 161, a pulse could have been employed instead of an impulse to cause the lock 161 to be unlocked.

A second computer program module 122 is connected to a second output channel 152 of the logic section 120 for controlling the door opener 162. The second module 122 is adapted to provide a pulse to the door opener 162 if it receives a signal at its input terminal. The pulse will cause the door opener 162 to open the door 163. The second module 122 has been provided by selecting the fourth computer program module type 213. Depending on the type of door opener 162, an impulse could have been employed instead of a pulse to cause the door 163 to be opened.

Third and fourth computer program modules 123 and 124 are employed to provide input to the second module 122. The third module 123 is an AND-module provided by selecting the second computer program module type 215. It receives the first 141 and third 143 input channels of the logic section 120 and provides a signal at its output terminal if signals have been received at both the first 141 and third 143 input channels (i.e. if an authorized user has presented a tag at the tag reader 134 and has pushed the push button 131).

The fourth module 124 is an OR-module provided by selecting the third computer program module type 218. It receives the second 142 input channel and the output from the third module 123. The fourth module 124 provides a signal at its output terminal if signals have been received at both the second input channel 142 and at the output terminal of the third module 123 (i.e. if a disabled authorized user has presented a tag at the tag reader 134 or if an authorized user has presented a tag at the tag reader and has pushed the push button 131).

In the present example, a third output channel 153 of the logic section 120 is not employed.

In the present example, one of the users needs extra time to enter the door 163 and has requested that the door 163 be opened for an extra long time. This attribute (i.e. extra long time, for example 20 seconds instead of the default value 10 seconds) has been entered in the database 190 as being associated with this user. If the logic section 110 finds that a received tag identity matches the tag identity of this user, the attribute is transmitted as a special attribute signal A to the logic section 120. The attribute signal A is employed as input by the second module 122 to prolong the pulse transmitted top the door opener 162 such that the door 163 stays open longer than usual.

It will be appreciated that the attribute signal A may for example include an explicit numerical value, such as the attributer value itself (for example 20 seconds), or signaling implicitly indicating that a certain numerical attribute value is to be employed.

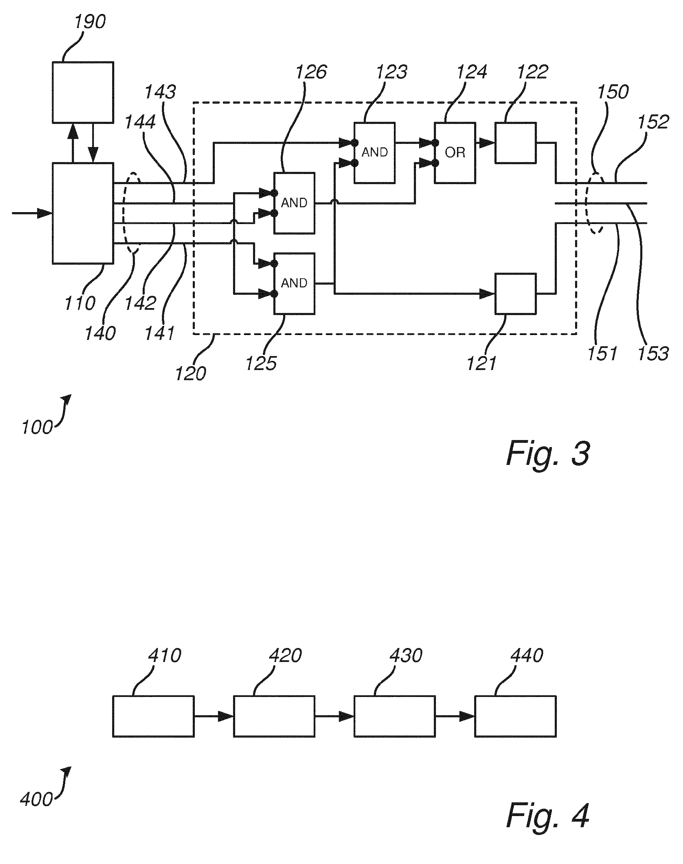

Fig. 3 is an overview of the access control system shown in Fig. 1, but where the functionality of the logic section 120 has been edited by adding further computer program modules. The same access control is desired as in the previous example, except that access is only to be allowed for the authorized users once a certain master user (for example a lecturer or instructor) has already arrived. Therefore, for each tag identity received from the tag reader 134, the input section 110 checks whether the received tag identity is the master user identity (i.e. is associated with a master access right). If the received tag identity is the master user identity, the input section provides a signal at the fourth input channel 144 of the logic section 120. Compared to the module structure described above with reference to Fig. 1, two AND-modules 125 and 126 have been added to ensure that the first and second input channels 141 and 142 do not activate the lock 161 or opener 162 unless the master user has already presented the master tag at the tag reader 134.

Since the logic section 120 is editable, this modification is easily performed by adding the two AND-modules 125 and 126, and by registering the master user in the database 190 as associated with the master access right.

As shown in the examples described with reference to Figs. 1 and 3, identities stored in the database 190 (or memory) may be associated with different access rights (for example a regular access right and a master access right). Each access right may be associated with an input channel 140 of the logic section 120. If a tag identity received from the tag reader 134 has one of these access rights (i.e. the identity is associated with an access right in the database 190) then a signal (for example a logic signal such as 1) is transmitted at the corresponding input channel 140 of the logic section 120.

The access control system 100 may be updated (or modified, or tailored) by adding, removing or replacing tag identities stored in the database 190, by adding, removing or replacing access rights associated with the identities in the database 190, and by selecting and connecting various computer program modules 121-126 via the computer interface 170. Editing of the database 190 may for example be performed via the computer interface 170 or via a different (or separate) computer interface.

Fig. 4 is a flow chart of an access control method 400 performed by the access control system 100. The method 400 comprises receiving 410 input signals from at least one of the input devices 130, and providing 420 signals through one or more of the input channels 140 based on the input signals. The method 400 comprises converting 430 the signals received through the input channels 140 into output signals by employing a function formed by one or more computer program modules 121-126. As described above, the function is editable by selecting the computer program modules 121-126 from a collection of available computer program module types and by selecting how to connect the selected computer program modules 121-126. The method 400 comprises outputting 440 the output signals through one or more of the output channels 150 for controlling at least one of the elements 160.

The person skilled in the art realizes that the present invention is by no means limited to the preferred embodiments described above. On the contrary, many modifications and variations are possible within the scope of the appended claims. For example, the logic section 120 may have any numbers of input channels 140 and output channels 150. Any number of computer program module types may be available for selection via the interface 180.

Although the examples described above with reference to Figs 1-4 have been described in terms of unlocking and opening a door 163, examples may also be envisaged wherein access control to a physical location may be provided by controlling locking/unlocking and/or opening/closing other elements, devices or components, such as a container.

It will be appreciated that any combination of the input devices 130 described with reference to Fig. 1 may be employed by an access control system to control any combination of the elements 160 described with reference to Fig. 1. For example, a single access control system may control access to multiple areas via control (for example via independent control) of locks and/or door openers arranged at several doors.

It will be appreciated that for example magnetic readers, biometric readers or any other input means from which an identity may be determined (or identified, or recognized) may be employed analogously as the tag reader 134 described with reference to Figs. 1-3.

It will be appreciated that the input section 110 and the logic section 120 may for example be arranged at different locations, or may be arranged within a common casing.

The skilled person realizes that the output signals provided by the logic section 120 in the output channels 150 may be based on currently received input signals (or current values of the input signals) as well as previously received input signals (or earlier values of the input signals)

Additionally, variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The division of tasks between functional units referred to in the present disclosure does not necessarily correspond to the division into physical units; to the contrary, one physical component may have multiple functionalities, and one task may be carried out in a distributed fashion, by several physical components in cooperation. A computer program may be stored/distributed on a suitable medium, such as an optical storage medium or a solid-state medium supplied together with or as part of other hardware, but may also be distributed in other forms, such as via the Internet or other wired or wireless telecommunication systems. The mere fact that certain measures are recited in mutually different dependent claims does not indicate that a combination of these measures cannot be used to advantage. Any reference signs in the claims should not be construed as limiting the scope.

## Claims

1. An access control system (100) comprising:
an input section (110) configured to receive input signals from at least one input device (130) from the group comprising:
a push button (131);
a manual switch (132);
a keypad (133);
a tag reader (134);
an optical reader;
a magnetic reader (135);
a wireless receiver;
a presence detector; and
a biometric reader; and
a logic section (120) having input channels (140) for receiving signals from the input section and output channels (150) for outputting signals for controlling at least one element (160) from the group comprising:
an electric strike;
an actuator;
an electric motor;
an electric lock (161); and
an opening mechanism (162) for a door (163),
wherein the input section is configured to provide signals through one or more of the input channels based on the input signals, wherein the logic section is configured to employ one or more computer program modules (121-126) together forming a function for converting the signals received through one or more of the input channels into signals output through one or more of the output channels, and wherein said function is editable via a computer interface (170) by selecting the one or more computer program modules from a collection of available computer program module types (211, 213, 215, 218) and by selecting how to connect the one or more selected computer program modules.

2. The system of claim 1, wherein the input section is configured to provide a signal through a certain input channel of the input channels in response to a certain criterion being satisfied by at least a subset of the input signals.

3. The system of claim 2, wherein the certain criterion includes that the at least a subset of the input signals matches at least one of a plurality of stored entries.

4. The system of claim 3, wherein the certain criterion includes that a stored entry matching the at least a subset of the input signals is associated with a certain access right.

5. The system of any of the preceding claims, wherein the input section is configured to:
check whether at least a subset of the input signals matches at least one of a plurality of stored entries; and
in response to a stored entry which matches the at least a subset of the input signals being associated with a certain attribute (A), signaling the certain attribute to the logic section.

6. The system of claim 5, wherein the collection of available computer program module types includes a computer program module (122, 211, 213) which has an output channel and which is adapted to provide a signal at its output channel based on said attribute.

7. The system of any of the preceding claims, wherein the collection of available computer program module types includes a computer program (121, 122, 211, 213) module having an input channel and an output channel, wherein the computer program module is adapted to provide a pulse or impulse at its output channel in response to receiving a signal at its input channel.

8. The system of claim 7, wherein the pulse provided at the output channel has a length or amplitude determined based on an attribute (A) signaled by the input section, or wherein the impulse provided at the output channel has an amplitude determined based on an attribute (A) signaled by the input section.

9. The system of any of the preceding claims, wherein the collection of available computer program module types includes a computer program module (123, 215) having a plurality of input channels and an output channel, the computer program module being adapted to provide a signal at its output channel in response to signals having been received at all of said plurality of input channels.

10. The system of any of the preceding claims, wherein the collection of available computer program module types includes a computer program module (124, 218) having a plurality of input channels and an output channel, the computer program module being adapted to provide a signal at its output channel in response to at least one signal having been received at one or more of its input channels.

11. The system of any of the preceding claims, wherein the input section is adapted to forward signals from an input device (131) of the at least one input device to at least one input channel (143) of the logic section.

12. The system of any of the preceding claims, further comprising the at least one input device.

13. The system of any of the preceding clams, further comprising the at least one element.

14. An access control method (400) comprising:
receiving (410) input signals from at least one input device (130) from the group comprising:
a push button (131);
a manual switch (132);
a keypad (133);
a tag reader (134);
an optical reader;
a magnetic reader (135);
a wireless receiver;
a presence detector; and
a biometric reader;
providing (420) signals through one or more input channels (140) based on the input signals;
converting (430) the signals received through the one or more input channels into output signals by employing a function formed by one or more computer program modules (121-126), wherein said function is editable by selecting the one or more computer program modules from a collection of available computer program module types (211, 213, 215, 218) and by selecting how to connect the one or more selected computer program modules; and
outputting (440) the output signals through one or more output channels (150) for controlling at least one element (160) from the group comprising:
an electric strike;
an actuator;
an electric motor;
an electric lock (161); and
an opening mechanism (162) for a door (163).

15. A computer program product comprising a computer-readable medium with instructions for performing the method of claim 14.

## Amended claims

### Amended claims in accordance with Rule 137(2) EPC.

1. An access control system (100) comprising:
an input section (110) configured to receive input signals from at least one input device (130) from the group comprising:
a push button (131);
a manual switch (132);
a keypad (133);
a tag reader (134);
an optical reader;
a magnetic reader (135);
a wireless receiver;
a presence detector; and
a biometric reader; and
a logic section (120) having input channels (140) for receiving signals from the input section and output channels (150) for outputting signals for controlling at least one element (160) from the group comprising:
an electric strike;
an actuator;
an electric motor;
an electric lock (161); and
an opening mechanism (162) for a door (163),
wherein the input section is configured to provide signals through one or more of the input channels based on the input signals, wherein the logic section is configured to employ one or more computer program modules (121-126) together forming a function for converting the signals received through one or more of the input channels into signals output through one or more of the output channels, wherein the access control system comprises a computer interface (170), wherein said function is editable via the computer interface by selecting the one or more computer program modules from a collection of available computer program module types (211, 213, 215, 218) and by selecting how to connect the one or more selected computer program modules, wherein the computer interface is arranged for connecting a user interface (180) to the logic section for performing the editing, wherein the input section is configured to provide a signal through a first input channel of the input channels in response to a first criterion being satisfied by at least a subset of the input signals, wherein the first criterion includes that the at least a subset of the input signals matches at least one of a plurality of stored entries, wherein the first criterion includes that a stored entry matching the at least a subset of the input signals is associated with a first access right, wherein the input section is configured to provide a signal through a second input channel of the input channels in response to a second criterion being satisfied by at least a subset of the input signals, and wherein the second criterion includes that the at least a subset of the input signals matches at least one of a plurality of stored entries and that a stored entry matching the at least a subset of the input signals is associated with a second access right.

2. The system of any of the preceding claims, wherein the input section is configured to:
check whether at least a subset of the input signals matches at least one of a plurality of stored entries; and
in response to a stored entry which matches the at least a subset of the input signals being associated with a certain attribute (A), signaling the certain attribute to the logic section,
wherein the collection of available computer program module types includes a computer program module (122, 211, 213) which has an output channel and which is adapted to provide a signal at its output channel based on said attribute, wherein a duration, amplitude or frequency of the signal provided at the output channel is determined based on the attribute.

3. The system of claim 2, wherein the computer program module has an input channel , wherein the computer program module is adapted to provide a pulse or impulse at its output channel in response to receiving a signal at its input channel,, wherein the pulse provided at the output channel has a length or amplitude determined based on the attribute (A) signaled by the input section, or wherein the impulse provided at the output channel has an amplitude determined based on the attribute (A) signaled by the input section.

4. The system of any of the preceding claims, wherein the collection of available computer program module types includes a computer program module (123, 215) having a plurality of input channels and an output channel, the computer program module being adapted to provide a signal at its output channel in response to signals having been received at all of said plurality of input channels.

5. The system of any of the preceding claims, wherein the collection of available computer program module types includes a computer program module (124, 218) having a plurality of input channels and an output channel, the computer program module being adapted to provide a signal at its output channel in response to at least one signal having been received at one or more of its input channels.

6. The system of any of the preceding claims, wherein the input section is adapted to forward signals from an input device (131) of the at least one input device to at least one input channel (143) of the logic section.

7. The system of any of the preceding claims, further comprising the at least one input device.

8. The system of any of the preceding clams, further comprising the at least one element.

9. An access control method (400) comprising:
receiving (410) input signals from at least one input device (130) from the group comprising:
a push button (131);
a manual switch (132);
a keypad (133);
a tag reader (134);
an optical reader;
a magnetic reader (135);
a wireless receiver;
a presence detector; and
a biometric reader;
providing (420) signals through one or more input channels (140) based on the input signals;
converting (430) the signals received through the one or more input channels into output signals by employing a function formed by one or more computer program modules (121-126), wherein said function is editable by selecting the one or more computer program modules from a collection of available computer program module types (211, 213, 215, 218) and by selecting how to connect the one or more selected computer program modules; and
outputting (440) the output signals through one or more output channels (150) for controlling at least one element (160) from the group comprising:
an electric strike;
an actuator;
an electric motor;
an electric lock (161); and
an opening mechanism (162) for a door (163),
wherein providing signals through one or more input channels based on the input signals comprises:
providing a signal through a first input channel of the input channels in response to a first criterion being satisfied by at least a subset of the input signals, wherein the first criterion includes that the at least a subset of the input signals matches at least one of a plurality of stored entries, and wherein the first criterion includes that a stored entry matching the at least a subset of the input signals is associated with a first access right; and
providing a signal through a second input channel of the input channels in response to a second criterion being satisfied by at least a subset of the input signals, wherein the second criterion includes that the at least a subset of the input signals matches at least one of a plurality of stored entries, and wherein the second criterion includes that a stored entry matching the at least a subset of the input signals is associated with a second access right.

10. A computer program product comprising a computer-readable medium with instructions for performing the method of claim 9.
